# FASCICULE DE BREVET EUROPEEN

(11) **EP 3 881 657 B1**
(45) Date de publication et mention de la délivrance du brevet: **09.11.2022**
(21) Numéro de dépôt: 19805235.9
(22) Date de dépôt: 14.11.2019
(51) Int. Cl.: H05K 7/20

(54) **CHAISE DE BAIE AVIONIQUE AVEC PLAQUE DE VENTILATION A JOINT INTERNE**
AVIONIKBAYTRÄGER MIT LÜFTERPLATTE MIT INNENDICHTUNG
AVIONICS BAY SUPPORT WITH VENTILATION PLATE WITH INTERNAL SEAL

(30) Priorité: 16.11.2018 FR 1871580
(43) Date de publication de la demande: 22.09.2021
(73) Titulaire: LATELEC, 31670 Occitanie Labege (FR)
(72) Inventeur: PUERTOLAS, Bastien, 31280 Aigrefeuille Occitanie (FR)
(74) Mandataire: Junca, Eric
(86) Numéro de dépôt international: PCT/EP2019/081277
(87) Numéro de publication internationale: WO 2020/099534

(56) Documents cités:
- CN-A- 104 302 128
- US-A- 4 044 515
- US-A- 4 458 296
- US-A- 4 888 664
- US-A- 5 170 320

## Description

### DOMAINE TECHNIQUE

L'invention concerne le domaine de l'aéronautique et, plus particulièrement, des baies avioniques pour aéronefs. L'invention vise une chaise utilisée dans les baies avioniques pour assurer le support, la connexion électrique, et la ventilation d'un module électrique rackable.

Les baies avioniques sont des armoires électriques embarquées dans un aéronef, qui permettent de loger des équipements électriques ou électroniques, tels que des calculateurs ou autres instruments, ainsi que les câblages électriques raccordant ces équipements. Ces baies avioniques sont généralement de taille conséquente et contiennent de nombreux équipements électroniques ou électriques proches les uns des autres, ainsi qu'une grande quantité de câbles. Une baie avionique comporte ainsi un dispositif de racks permettant l'insertion et le retrait de modules électriques contenant les équipements. Une baie avionique comporte de plus nécessairement un dispositif de refroidissement garantissant le maintien des équipements dans une plage de température acceptable pour leur fonctionnement. Les dispositifs de refroidissement pour baie avionique comportent généralement des éléments assurant la ventilation des équipements grâce à la circulation d'un gaz tel que de l'air.

Les modules électriques sont dits « rackables » car leur forme et dimensions sont conformes à une norme leur permettant d'être compatibles avec des moyens de support, de connexion électrique, et de ventilation montés dans la baie, et dénommés « chaises ».

### ART ANTÉRIEUR

Les chaises de baie avionique, destinées à supporter, connecter électriquement, et ventiler un module électrique rackable, sont actuellement utilisées dans tous les avions. Par exemple, les chaises de baie avionique suivant la norme ARINC 600 comportent une paroi d'interface fluidique avec la baie avionique reliée à une paroi adjacente de connexion électrique, la paroi d'interface fluidique comportant des orifices de ventilation ainsi que des moyens de fixation d'un module électrique rackable contre la paroi d'interface fluidique.

Les documents US4044515 et US4888664, par exemple, décrivent un tel module.

Les orifices de ventilation de la paroi d'interface fluidique sont les orifices par lesquels la chaise reçoit le flux de ventilation de la baie avionique et le distribue au module qui est fixé sur cette chaise. Dans une baie avionique, le flux de ventilation distribué à chaque module est calibré. Afin d'assurer une bonne répartition de la ventilation entre les différents modules de la baie avionique, chaque module ne doit recevoir que le débit d'air qui lui est nécessaire.

Si la section de passage de l'air de ventilation est trop importante au niveau de l'un des modules, le flux de ventilation se dirigera essentiellement vers ce module, de sorte que les modules voisins ne seront pas suffisamment ventilés.

Pour des raisons de rationalisation de la production industrielle, les chaises de baie avionique d'une même taille sont standardisées et ont généralement toutes le même nombre d'orifices de ventilations. Chaque chaise possède un nombre maximal de trous, correspondant à la section de passage d'air de ventilation maximale qui peut être mise en œuvre pour cette chaise particulière. Lors de la fabrication d'une baie avionique spécifique à un avion donné, les chaises seront mises en place et leur section de passage pour la ventilation sera calibré en bouchant un certain nombre des orifices de ventilation à l'aide de bouchons étanches. Cette opération est une opération manuelle, difficile à intégrer dans un procédé de production industrielle automatisée, et qui est source d'erreurs potentielles.

Ces chaises connues comportent par ailleurs, généralement, un joint à lèvre entourant l'ensemble des orifices de ventilation et garantissant l'étanchéité entre la chaise et le module électrique qui est fixé dessus, de sorte que le flux de ventilation traversant les orifices de ventilation pénètre bien dans le module, sans qu'il y ait de fuite à l'interface entre la paroi d'interface fluidique de la chaise et le module. Ce joint à lèvre est apparent et accessible sur la chaise tant qu'un module n'a pas été fixé sur cette chaise. Ainsi, en cours de fabrication de la baie avionique, ou pendant des phases de maintenance où des modules sont enlevés de leur chaise respective, les joints à lèvres sont soumis aux agressions extérieures et risquent d'être dégradés accidentellement par tout objet dur ou tranchant. De plus, en dehors du risque de dégradation accidentelle du joint, ce dernier est soumis à des frottements mécaniques lors de l'installation ou de la dépose du module sur la chaise, opérations durant lesquelles des mouvements d'avant en arrière du module par rapport à la chaise entrainent un frottement de la face inférieure du module sur le joint à lèvre. L'intégrité et la longévité de ce joint à lèvre sont des qualités essentielles pour le bon fonctionnement de la ventilation de la baie avionique.

Par ailleurs, lorsque le module est en place et sur la chaise, l'espace qui est délimité par le joint à lèvre, et dans lequel les orifices de ventilation débouchent, présente un volume variable en fonction de l'enfoncement du joint à lèvre, c'est-à-dire en fonction de la force exercée par le module sur la chaise, et en fonction des tolérances géométriques du modules et de la chaise rendant incertaines les zones de butées et donc l'écrasement maximal local possible du joint. Cette variation de volume non maitrisée, à l'endroit où les orifices de ventilation débouchent, peut entrainer des perturbations dans l'écoulement de la ventilation. Lorsque le joint à lèvre vieillit, le volume délimité par le joint à lèvre où les flux issus de chacun des orifices de ventilation se mélangent, peut diminuer.

### EXPOSÉ DE L'INVENTION

L'invention a pour but d'améliorer les chaises de baie avionique de l'art antérieur.

À cet effet, l'invention vise une chaise de baie avionique destinée à supporter, connecter électriquement, et ventiler un module électrique rackable, cette chaise comportant une paroi d'interface fluidique avec la baie avionique et une paroi adjacente de connexion électrique, la paroi d'interface fluidique comportant des orifices de ventilation calibrés ainsi que des moyens de fixation d'un module électrique rackable contre la paroi d'interface fluidique. La paroi d'interface fluidique comporte :
- une fenêtre de ventilation ;
- un encadrement de support disposé autour de la fenêtre de ventilation et présentant une surface d'appui pour un module électrique rackable ;
- une plaque de ventilation portant les orifices de ventilation ;
la plaque de ventilation étant munie sur sa périphérie d'une collerette et de surfaces d'arrêt disposées en vis-à-vis de la collerette, la plaque de ventilation comportant en outre :
- une chambre de diffusion dans laquelle débouchent les orifices de ventilation ;
- une piste de contact pour le module électrique rackable, cette piste de contact entourant la chambre de diffusion ;
la plaque de ventilation étant montée dans la fenêtre de ventilation de sorte que la collerette et les surfaces d'arrêt enserrent le rebord de la fenêtre de ventilation avec un jeu comblé par un joint élastique disposé entre la collerette et le rebord de la fenêtre de ventilation, le plan dans lequel s'étend la piste de contact étant à l'écart du plan dans lequel s'étend la surface d'appui de l'encadrement de support.

Un autre objet de l'invention vise un procédé de fabrication d'une baie avionique telle que décrite ci-dessus, ce procédé comportant les étapes suivantes :
- déterminer la perméabilité au flux de ventilation adéquate pour la chaise de baie avionique en fonction du module électrique rackable à installer ;
- choisir parmi une pluralité de plaques de ventilation procurant différentes perméabilités au flux de ventilation, une plaque de ventilation dont la perméabilité au flux de ventilation correspond à la perméabilité au flux de ventilation déterminée ;
- monter la plaque de ventilation choisie dans la fenêtre de ventilation de la chaise.

Selon une caractéristique préférée, chaque plaque de ventilation de la pluralité de plaques de ventilation présente une identification visuelle spécifique de la perméabilité au flux de ventilation qu'elle procure.

Une telle chaise de baie avionique présente une paroi d'interface fluidique dépourvue de joint apparent. Ainsi, aucun frottement ou accrochage intempestif au niveau de cette paroi d'interface fluidique n'entrainera de dégradation de l'étanchéité. Cette étanchéité entre la chaise et le module est primordiale pour une ventilation optimale du module et le bon fonctionnement général de la baie avionique, le refroidissement d'une baie avionique étant une fonction critique dans le domaine de l'aéronautique.

Par ailleurs, la structure de la chaise et notamment le mode de montage de la plaque de ventilation sur l'encadrement de support permet de dissocier les fonctions de calibrage du flux de ventilation des fonctions d'étanchéité de l'interface, ce qui implique qu'une telle chaise peut bénéficier d'un calibrage de son flux de ventilation par simple changement de la plaque de ventilation. Ainsi, lors de la fabrication de la chaise, durant l'étape de calibrage du flux de ventilation pour l'adapter à un module spécifique, l'opération pourra consister simplement à choisir, parmi une pluralité de plaques de ventilation, la plaque de ventilation adaptée. La plaque de ventilation choisie sera montée, par exemple par clipsage, sur l'encadrement de support. Une telle opération est plus simple, plus rapide, et plus facilement automatisable que la pose de bouchons individuels sur les orifices de ventilation. Par ailleurs, que l'opération soit manuelle ou automatisée, le risque d'erreur est considérablement réduit puisque l'opération de calibrage repose sur un simple choix de la plaque de ventilation adaptée, qui peut être identifiée par un code couleur ou un marquage très visible.

De plus, la chambre de diffusion de la ventilation présente un volume constant, indépendant des conditions de montage du module et du niveau de compression du joint élastique, ce qui garantit le maintien d'un mélange optimal des flux de ventilation arrivant par l'ensemble des orifices de ventilation.

Par ailleurs, lors des phases de maintenance, une nouvelle plaque de ventilation munie de son joint élastique peut être rapidement installée à la place d'une plaque de ventilation défectueuse sans avoir à démonter la chaise de la baie avionique et donc sans avoir à déconnecter le câblage de cette chaise.

La chaise de baie avionique peut comporter les caractéristiques additionnelles suivantes, seules ou en combinaison :
- la plaque de ventilation comporte sur sa tranche une gorge pour le joint élastique, cette gorge s'étendant sur toute la périphérie de la plaque de ventilation, en vis-à-vis des surfaces d'arrêt ;
- la plaque de ventilation comporte sur sa tranche une casquette de protection du joint élastique, cette casquette de protection s'étendant sur toute la périphérie de la plaque de ventilation ;
- les surfaces d'arrêt sont formées par des pattes élastiques s'étendant sensiblement perpendiculairement à la plaque de ventilation, ces pattes élastiques étant réparties sur le pourtour de la plaque de ventilation ;
- les pattes élastiques comportent des pentes de clipsage de la plaque de ventilation dans la fenêtre de ventilation ;
- la chambre de diffusion est formée par une cuvette réalisée dans l'épaisseur de la plaque de ventilation, les bords de cette cuvette formant la piste de contact ;
- l'encadrement de support comporte un renfoncement autour de la fenêtre de ventilation de sorte que le rebord de la fenêtre de ventilation soit écarté du plan dans lequel s'étend la surface d'appui de l'encadrement de support ;
- la plaque de ventilation est élastiquement déformable ;
- la plaque de ventilation est réalisée d'une seule pièce ;
- la plaque de ventilation est réalisée en un polymère ;
- le joint élastique sollicite un écartement entre la collerette et le rebord de la fenêtre de ventilation, et sollicite les surfaces d'arrêt contre le rebord de la fenêtre de ventilation ;
- le plan dans lequel s'étend la piste de contact est sensiblement parallèle au plan dans lequel s'étend la surface d'appui de l'encadrement de support ;
- la piste de contact présente une surface plane.

### PRÉSENTATION DES FIGURES

D'autres caractéristiques et avantages de l'invention ressortiront de la description qui en est faite ci-après, à titre indicatif et nullement limitatif, en référence aux dessins annexés, dans lesquels :
[Fig.1] La figure 1 est une représentation schématique, de face, d'une baie avionique ;
[Fig.2] La figure 2 est une vue de détail de la figure 1, représentant schématiquement l'agencement d'une chaise selon l'invention dans la baie avionique de la figure 1 ;
[Fig.3] La figure 3 représente en perspective une chaise selon l'invention ;
[Fig.4] La figure 4 est une vue en coupe partielle de la chaise de la figure 3 montrant la coopération entre la plaque de ventilation et le rebord de la fenêtre de ventilation ;
[Fig.5] La figure 5 est une vue similaire à la figure 4, un module électrique étant monté sur la chaise ;

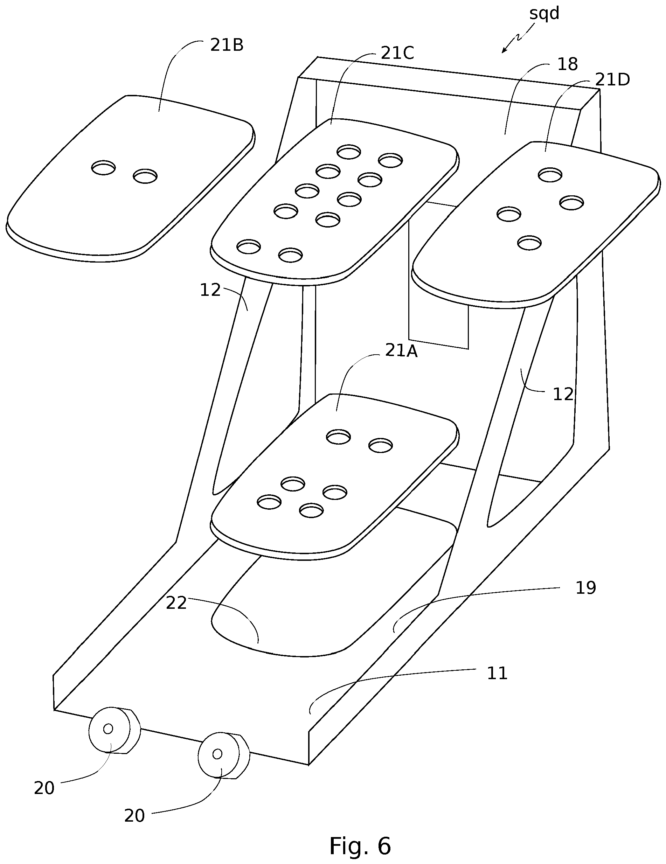

[Fig.6] La figure 6 illustre une étape dans le procédé de fabrication de la chaise de la figure 3.

### DESCRIPTION DÉTAILLÉE

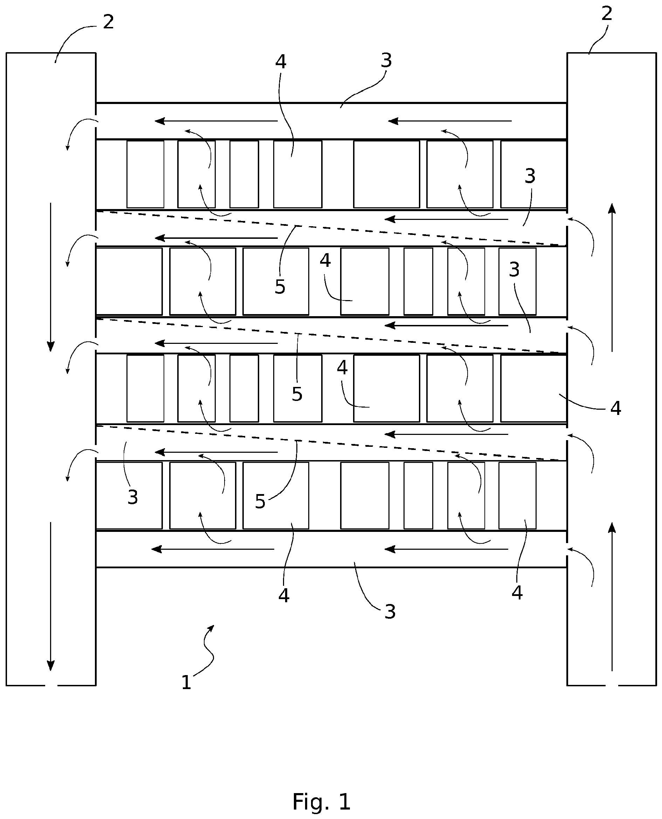

La figure 1 représente une baie avionique 1, selon une vue schématique illustrant le circuit de ventilation mis en œuvre pour refroidir les équipements électriques et électroniques montés dans la baie 1.

La baie avionique 1 comporte deux montants latéraux 2 et des étagères 3 s'étendant entre les montants latéraux 2. Des modules électriques rackables 4 sont montés sur les étagères 3.

La baie avionique 1 assure le support mécanique des modules 4, ainsi que leur connexion électrique. Par ailleurs, un circuit de ventilation passe, dans le présent exemple, par les montants latéraux 2 pour être distribué aux étagères 3. Ce circuit de ventilation est prévu pour assurer le refroidissement des équipements électriques et électroniques contenus dans les modules 4. Les flèches visibles à la figure 1 schématisent la circulation du flux d'air, ou de tout autre fluide de refroidissement adéquat, au sein de la baie avionique 1.

Les étagères 3 comportent ici des parois 5 de séparation, ou tout autre conduit adapté, créant des volumes de ventilation adaptés à conduire l'air de ventilation jusque sous les modules 4, de sorte que cet air de ventilation traverse les modules 4 et les refroidisse. Le flux de ventilation ainsi réchauffé est ensuite évacué par l'étagère au-dessus des modules 4 et sort ensuite de la baie avionique 1 par l'un des montants latéraux 2.

Le flux de ventilation traversant chaque module 4 est calibré. En effet, les modules de la baie avionique diffèrent les uns des autres pour ce qui est de leur largeur, des composants électriques ou électroniques (éventuellement de puissance) qu'ils renferment, et de la densité de ces composants. Les besoins de refroidissement d'un module à l'autre ne sont donc pas homogènes. Ces besoins en refroidissement sont en général définis par la norme aéronautique s'appliquant à la baie avionique destinée à un avion particulier, ces normes définissant généralement le nombre de mètres cubes d'air de refroidissement à distribuer par heure à un module 4 en fonction de la puissance consommée ou dissipée par ce module 4. Par ailleurs, les calculs de mécanique des fluides mis en œuvre lors de la conception d'une baie avionique 1 particulière répartissent les modules 4 au sein de la baie 1 pour garantir un écoulement optimal du flux de refroidissement. Le calibrage de la portion du flux de ventilation que doit recevoir un module 4 particulier est primordial dans la conception d'une baie avionique 1 et conditionne sa fiabilité et sa durée de vie. La section de passage de flux d'air, calibrée pour un module, est généralement dénommée « perméabilité », ou encore « porosité » ou « taux d'ouverture ».

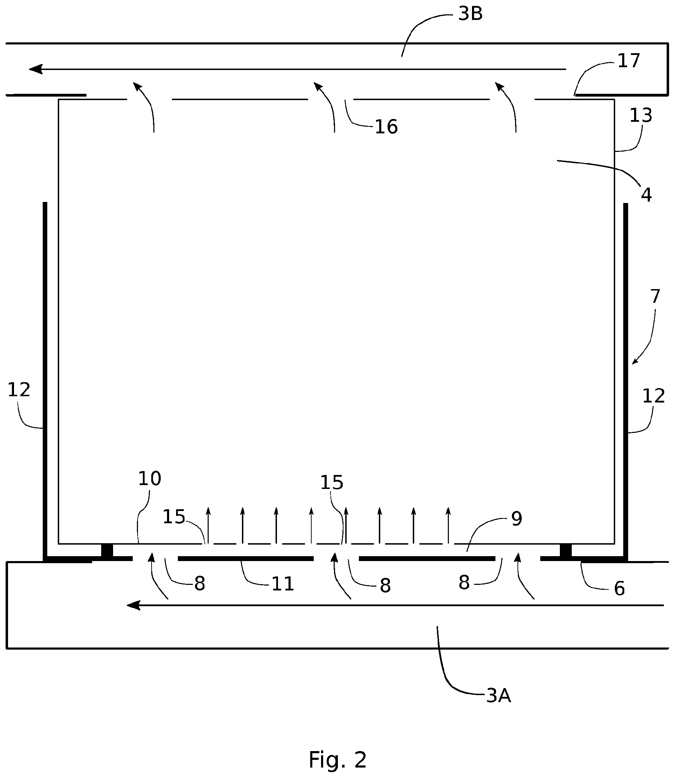

La figure 2 est une vue de détail de l'un des modules 4 de la figure 1 illustrant schématiquement la manière dont est organisée et calibrée la perméabilité pour ce module 4.

L'étagère inférieure 3A, située sous le module 4, forme un conduit par lequel le flux de ventilation parvient au module 4. L'étagère inférieure 3A comporte une fenêtre 6 permettant un large passage du flux de ventilation en direction du module 4.

Le module 4 est monté sur l'étagère inférieure 3A par l'intermédiaire d'une chaise 7 de baie avionique. Cette chaise 7 est fixée sur l'étagère inférieure 3A, de sorte que le flux de ventilation issu de la fenêtre 6 traverse la chaise 7. La chaise 7 comporte une paroi inférieure qui est une paroi d'interface fluidique 11 et deux parois latérales de structure 12. La traversée de la chaise 7 par le flux de ventilation est réalisée via des orifices de ventilation calibrés 8 situés sur la paroi d'interface fluidique. Le module 4 est fixé sur la chaise 7 de sorte qu'une chambre de diffusion 9 est créée entre la paroi inférieure 10 du module 4 et la paroi d'interface fluidique 11 de la chaise 7.

Le module 4 comporte quant à lui un boitier externe 13 renfermant et protégeant les circuits électriques et électroniques qu'il contient. La paroi 10 du boitier 13 qui est en vis-à-vis de la paroi d'interface fluidique 11 de la chaise 7 est percée de nombreux trous ou rainures 15 permettant le passage du flux de ventilation calibré par les orifices de ventilation 8.

La chambre de diffusion 9 assure l'interface entre les orifices de ventilation 8 et les trous 15 du module 4. Le flux de ventilation traverse ainsi les orifices de ventilation 8, se répartit de manière optimale dans la chambre de diffusion 9, et est diffusé dans le module 4.

En sortie de module 4, le flux de ventilation traverse des trous 16, situés dans la partie supérieure du boitier 13, et rejoint un ensemble de trous 17 de l'étagère supérieure 3B, pour être évacué par aspiration.

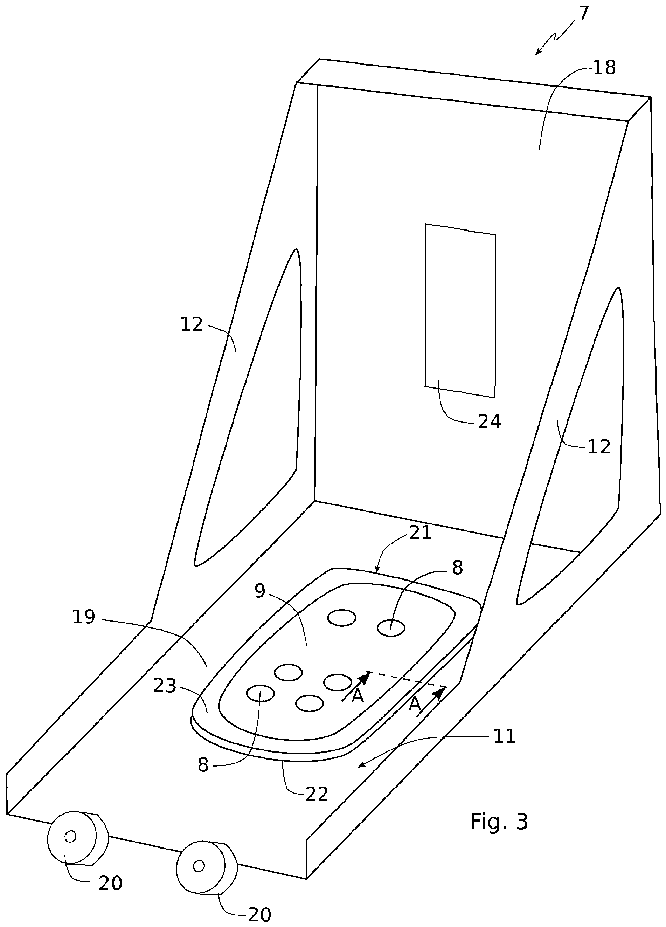

La figure 3 représente en perspective la chaise 7 de baie avionique utilisée pour le montage des modules 4 sur les étagères 3.

La chaise 7 comporte une base constituée de la paroi d'interface fluidique 11 qui est reliée à une paroi adjacente 18 de connexion électrique. Ces deux parois 11, 18 sont sensiblement perpendiculaires et sont maintenues ensemble par deux parois de structure 12.

La paroi de connexion électrique 18 comporte une zone de connexion 24 destinée à recevoir des connecteurs compatibles avec le module 4 qui sera monté sur la chaise 7.

La paroi d'interface fluidique 11 comporte un encadrement de support 19 sur lequel vient prendre appui la paroi inférieure 10 du module 4 lorsque ce dernier est en place dans la chaise 7. L'encadrement de support 19 assure à lui seul le support mécanique du module 4.

La paroi d'interface fluidique 11 comporte également des moyens de fixation 20 du module 4 contre l'encadrement de support 19, ces moyens de fixation 20 pouvant être constitués par des vis à molette, des dispositifs à genouillère, ou toute autre fixation connue.

Une fenêtre de ventilation 22 est pratiquée dans la partie centrale de l'encadrement de support 19. Une plaque de ventilation 21 comportant les orifices de ventilation 8 calibrés est montée dans la fenêtre de ventilation 22. La perméabilité au flux de ventilation de la chaise 7 est calibrée par les diamètres et le nombre des orifices de ventilation 8 au sein de la plaque de ventilation 21.

La plaque de ventilation 21 comporte sur son pourtour une piste de contact 23 destinée à venir s'appuyer entièrement contre le module 4 lorsque ce dernier est en place dans la chaise 7. Sur la plaque de ventilation 21, la piste de contact 23 entoure une chambre de diffusion 9 dans laquelle débouchent les orifices de ventilation 8.

La plaque de ventilation 21 est réalisée en un matériau élastiquement déformable pour épouser la forme de la paroi inférieure 10 du module 4 et garantir que la piste de contact 23 soit entièrement au contact de cette paroi 10 malgré les éventuels défauts de planéité de cette dernière. La plaque de ventilation 21 peut par exemple être réalisée en un polymère thermoformable tel que l'ABS ou le polycarbonate.

Dans la configuration de la figure 3, le module 4 n'étant pas monté dans la chaise 7, la piste de contact 23 de la plaque de ventilation 21 est surélevée par rapport au plan dans lequel s'étend l'encadrement de support 19.

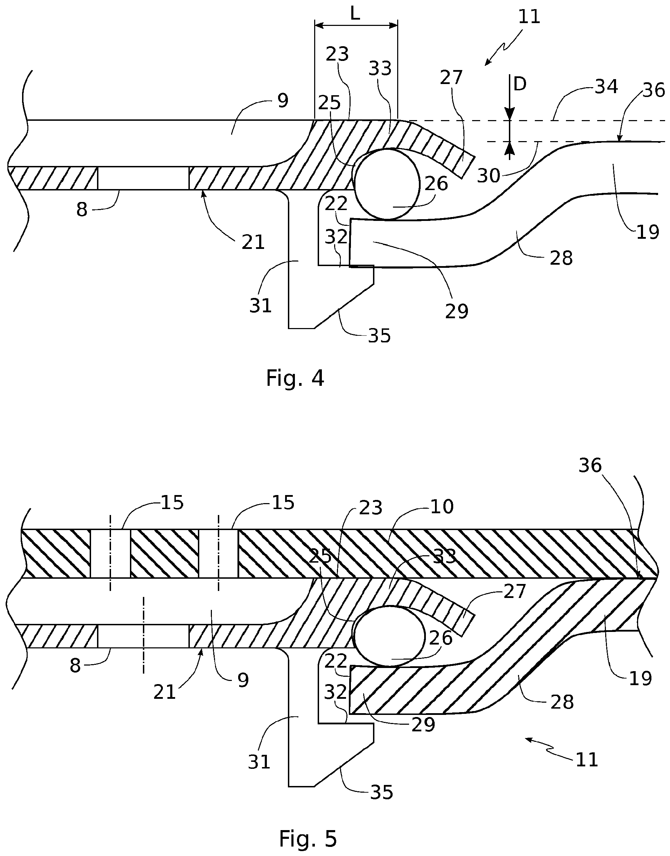

Les figures 4 et 5 sont des vues en coupe selon la coupe AA visible à la figure 3. Ces vues en coupe illustrent la coopération de la plaque de ventilation 21 avec l'encadrement de support 19 et le rebord de la fenêtre de ventilation 22.

La figure 4 représente la plaque de ventilation 21 et l'encadrement de support 19 dans leur configuration de la figure 3, c'est-à-dire lorsque le module 4 n'est pas en place dans la chaise 7. La figure 5 illustre ces mêmes éléments lorsque le module 4 est fixé sur la chaise 7.

En référence à la figure 4, la plaque de ventilation 21 comporte sur sa tranche une collerette 33 qui s'étend sur toute la périphérie de la plaque de ventilation 21. Sous la collerette 33, est située une gorge 25 s'étendant également sur toute la périphérie de la plaque 21. Un joint élastique 26 est monté dans la gorge 25 de sorte que le joint 26 est disposé en vis-à-vis de la collerette 33. Dans le présent exemple, le joint élastique 26 est un joint torique entourant complètement la plaque de ventilation 21. Une casquette de protection 27 du joint 26 est également disposée dans le prolongement de la collerette 33, sur tout le pourtour de la plaque de ventilation 21 pour éviter un accès direct au joint 26 depuis la paroi d'interface fluidique.

La vue en coupe de la figure 4 montre que la chambre de diffusion 9 est creusée dans l'épaisseur de la plaque de ventilation 21. La chambre de diffusion 9 est ainsi formée par une cuvette réalisée dans l'épaisseur de la plaque de ventilation 21, les bords de cette cuvette formant la piste de contact 23.

L'encadrement de support 19 présente une surface d'appui 36 pour le module 4, ainsi qu'un renfoncement 28 permettant au rebord 29 de la fenêtre de ventilation 22 d'être situé sous le niveau du plan 30 dans lequel s'étend la surface d'appui 36.

La plaque de ventilation 21 enserre le rebord 29 de la fenêtre de ventilation grâce à des pattes élastiques 31 présentant chacune une surface d'arrêt 32 disposée en vis-à-vis de la collerette 33. Ces pattes élastiques 31 sont réparties sur tout le pourtour de la plaque de ventilation 21 et sont munies de pentes de clipsage 35 pour faciliter le montage de la plaque de ventilation 21 dans la fenêtre de ventilation 22. La plaque de ventilation 21 peut être moulée d'une seule pièce incluant les pattes élastiques 31 par tout procédé de plasturgie tel que le moulage par injection.

Le joint 26 comble l'espace entre la collerette 33 et le rebord 29. Le joint 26, par ses propriétés élastiques, sollicite donc un écartement entre la plaque de ventilation 21 et l'encadrement de support 19, ce qui a pour conséquence de solliciter les surfaces d'arrêt 32 des pattes élastiques 31 contre le rebord 29.

Dans la configuration de la figure 4, le plan 34 dans lequel s'étend la piste de contact 23 est à une distance D au-dessus du plan 30 dans lequel s'étend l'encadrement de support 19. Aucun joint d'étanchéité n'est apparent ni accessible sur la paroi d'interface fluidique 11, de sorte que les frottements du module 4 sur la paroi d'interface fluidique 11 durant son installation et sa connexion sont inoffensifs pour les moyens d'étanchéité relatifs au flux de ventilation.

En référence à la figure 5, lorsqu'un module 4 est fixé sur la chaise 7, la paroi inférieure 10 du module 4 vient solliciter la plaque de ventilation 21 en direction de l'encadrement de support 19. La paroi 10, sensiblement plane, vient mettre à niveau la piste de contact 23 avec la surface d'appui 36 de l'encadrement de support 19. La plaque de ventilation 21 est repoussée par la paroi, la compression du joint 26 permettant ce mouvement de la plaque de ventilation 21. Ainsi, l'encadrement de support 19 remplit sa fonction de support mécanique en formant un socle pour la réception du module 4, tandis que la piste de contact 23 est sollicitée contre la paroi 10 par la raideur du joint élastique 26 comprimé. Les propriétés élastiquement déformables de la plaque de ventilation 21, et donc de la piste de contact 23, ainsi que la sollicitation du joint 26 présente sur tout le pourtour de la plaque de ventilation 21, permettent à la piste de contact 23 d'être dument en contact, sur toute sa longueur, avec la paroi 10, sans fuites.

Le contact plan sur plan de la piste de contact 23 et de la paroi 10 du module 4, associé à la sollicitation du joint 26, permet d'assurer une étanchéité suffisante pour la circulation d'un flux de ventilation basse pression c'est-à-dire jusqu'aux alentours de 300 pascals.

À cet effet, la largeur L de la piste de contact 23 a une dimension minimale de 3 millimètres.

Par ailleurs, la distance de compression D est de préférence comprise entre 0,5 et 1,5 mm, et raideur obtenue par la compression du joint 26 est de préférence comprise entre 20 et 50 kN/m.

Dans cette configuration de la figure 5, les surfaces d'arrêt 32 des pattes élastiques 31 sont à l'écart du rebord 29 de la fenêtre de ventilation 22.

La chambre de diffusion 9 présente toujours le même volume, quel que soit le niveau de compression du joint 26.

Le montage de la plaque de ventilation 21 est avantageusement réalisé par une seule opération de clipsage de la plaque de ventilation 21 dans la fenêtre de ventilation 22, grâce aux pattes élastiques 31.

Ainsi, le procédé de fabrication d'une chaise 7 de perméabilité prédéterminée est considérablement simplifié. Durant ce procédé, l'ensemble des éléments de la chaise 7 sont assemblés de manière classique puis, en bout de chaine, la plaque de ventilation 21 est clipsée dans la fenêtre de ventilation 22. Le dispositif automatisé, ou l'opérateur, en charge de cette opération de bout de chaine choisit parmi une pluralité de plaques de ventilation 21, dont chacune procure une perméabilité déterminée à la chaise 7. La perméabilité spécifique à chacune des plaques de ventilation 21 peut être visuellement indiquée par une couleur ou un marquage bien visible pour diminuer le risque d'erreur. En cas de montage manuel, une plaque de ventilation 21 d'une couleur déterminée offre ainsi un contrôle visuel bien plus fiable que le fait de repérer et compter des bouchons dans les orifices de ventilation 8, la chaise 7 selon l'invention se passant complètement de ce type de bouchons.

Des variantes de réalisation de la chaise de baie avionique peuvent être envisagées sans sortir du cadre de l'invention. Par exemple, le présent exemple vise une chaise délivrant un flux de ventilation par le dessous d'un module, étant entendu que la paroi d'interface fluidique 11 de la chaise 7 peut être prévue selon d'autres orientations, par exemple sur le haut du module ou sur les faces latérales. Par ailleurs, l'état de surface de la piste de contact 23 peut être traité pour améliorer la surface de contact entre cette dernière et le module, par exemple grâce à un polissage. Le joint élastique 26 peut présenter toute autre forme que celle décrite à condition d'assurer l'étanchéité entre la plaque de ventilation 21 et l'encadrement de support 19, et de procurer également une raideur sollicitant en écartement la plaque de ventilation 21 et l'encadrement de support 19. Le joint élastique 26 peut également être moulé directement avec la plaque de ventilation 21 (moulage [bimatière).]

## Revendications

1. Chaise (7) de baie avionique (1) destinée à supporter, connecter électriquement, et ventiler un module électrique rackable (4), cette chaise (7) comportant une paroi d'interface fluidique (11) avec la baie avionique (1) et une paroi adjacente de connexion électrique (18), la paroi d'interface fluidique (11) comportant des orifices de ventilation (8) calibrés ainsi que des moyens de fixation (20) d'un module électrique rackable (4) contre la paroi d'interface fluidique (11), la paroi d'interface fluidique (11) comportant aussi :
- une fenêtre de ventilation (22) ;
- un encadrement de support (19) disposé autour de la fenêtre de ventilation (22) et présentant une surface d'appui (36) pour un module électrique rackable (4) ;
- une plaque de ventilation (21) portant les orifices de ventilation (8) ; cette chaise de baie avionique étant **caractérisée en ce que** la plaque de ventilation (21) est munie sur sa périphérie d'une collerette (33) et de surfaces d'arrêt (32) disposées en vis-à-vis de la collerette (33), la plaque de ventilation (21) comportant en outre :
- une chambre de diffusion (9) dans laquelle débouchent les orifices de ventilation (8) ;
- une piste de contact (23) pour le module électrique rackable (4), cette piste de contact (23) entourant la chambre de diffusion (9) ;
la plaque de ventilation (21) étant montée dans la fenêtre de ventilation (22) de sorte que la collerette (33) et les surfaces d'arrêt (32) enserrent le rebord (29) de la fenêtre de ventilation (22) avec un jeu comblé par un joint élastique (26) disposé entre la collerette (33) et le rebord (29) de la fenêtre de ventilation (22), le plan (34) dans lequel s'étend la piste de contact (23) étant à l'écart du plan (30) dans lequel s'étend la surface d'appui (36) de l'encadrement de support.

2. Chaise selon la revendication 1, **caractérisée en ce que** la plaque de ventilation (21) comporte sur sa tranche une gorge (25) pour le joint élastique (26), cette gorge (25) s'étendant sur toute la périphérie de la plaque de ventilation (21), en vis-à-vis des surfaces d'arrêt (32).

3. Chaise selon l'une quelconque des revendications précédentes, **caractérisée en ce que** la plaque de ventilation (21) comporte sur sa tranche une casquette de protection (27) du joint élastique (26), cette casquette de protection (27) s'étendant sur toute la périphérie de la plaque de ventilation (21).

4. Chaise selon l'une quelconque des revendications précédentes, **caractérisée en ce que** les surfaces d'arrêt (32) sont formées par des pattes élastiques (31) s'étendant sensiblement perpendiculairement à la plaque de ventilation (21), ces pattes élastiques (31) étant réparties sur le pourtour de la plaque de ventilation (21).

5. Chaise selon la revendication 4, **caractérisée en ce que** les pattes élastiques (31) comportent des pentes de clipsage (35) de la plaque de ventilation (21) dans la fenêtre de ventilation (22).

6. Chaise selon l'une quelconque des revendications précédentes, **caractérisée en ce que** la chambre de diffusion (9) est formée par une cuvette réalisée dans l'épaisseur de la plaque de ventilation (21), les bords de cette cuvette formant la piste de contact (23).

7. Chaise selon l'une quelconque des revendications précédentes, **caractérisée en ce que** l'encadrement de support (19) comporte un renfoncement (28) autour de la fenêtre de ventilation (22) de sorte que le rebord (29) de la fenêtre de ventilation (22) soit écarté du plan (30) dans lequel s'étend la surface d'appui (36) de l'encadrement de support (19).

8. Chaise selon l'une quelconque des revendications précédentes, **caractérisée en ce que** la plaque de ventilation (21) est élastiquement déformable.

9. Chaise selon l'une quelconque des revendications précédentes, **caractérisée en ce que** la plaque de ventilation (21) est réalisée d'une seule pièce.

10. Chaise selon l'une des revendications 8 ou 9, **caractérisée en ce que** la plaque de ventilation (21) est réalisée en un polymère.

11. Chaise selon l'une quelconque des revendications précédentes, **caractérisée en ce que** le joint élastique (26) sollicite un écartement entre la collerette (33) et le rebord (29) de la fenêtre de ventilation (22), et sollicite les surfaces d'arrêt (32) contre le rebord (29) de la fenêtre de ventilation (22).

12. Chaise selon l'une quelconque des revendications précédentes, **caractérisée en ce que** le plan (34) dans lequel s'étend la piste de contact (23) est sensiblement parallèle au plan (30) dans lequel s'étend la surface d'appui (36) de l'encadrement de support (19).

13. Chaise selon l'une quelconque des revendications précédentes, **caractérisée en ce que** la piste de contact (23) présente une surface plane.

14. Procédé de fabrication d'une baie avionique, mettant en œuvre une chaise de baie avionique conforme à l'une quelconque des revendications 1 à 13, **caractérisée en ce qu'**il comporte les étapes suivantes :
- déterminer la perméabilité au flux de ventilation adéquate pour la chaise de baie avionique en fonction du module électrique rackable à installer ;
- choisir parmi une pluralité (21A, 21B, 21C, 21D) de plaques de ventilation procurant différentes perméabilités au flux de ventilation, une plaque de ventilation dont la perméabilité au flux de ventilation correspond à la perméabilité au flux de ventilation déterminée ;
- monter la plaque de ventilation choisie dans la fenêtre de ventilation (22) de la chaise (7).

15. Procédé selon la revendication 14, **caractérisée en ce que** chaque plaque de ventilation de la pluralité de plaques de ventilation (21A, 21B, 21C, 21D) présente une identification visuelle spécifique de la perméabilité au flux de ventilation qu'elle procure.

## Patentansprüche

1. Gestell (7) einer Avionikbucht (1), das dazu bestimmt ist, ein rackfähiges elektrisches Modul (4) zu tragen, elektrisch zu verbinden und zu belüften, wobei dieses Gestell (7) eine Fluidschnittstellenwand (11) mit der Avionikbucht (1) und eine angrenzende Wand zur elektrischen Verbindung (18) aufweist, wobei die Fluidschnittstellenwand (11) kalibrierte Belüftungsöffnungen (8) sowie Befestigungseinrichtungen (20) eines rackfähigen elektrischen Moduls (4) gegen die Fluidschnittstellenwand (11) aufweist, wobei die Fluidschnittstellenwand (11) auch aufweist:
- ein Belüftungsfenster (22);
- einen Stützrahmen (19), der um das Belüftungsfenster (22) herum angeordnet ist und eine Auflagefläche (36) für ein rackfähiges elektrisches Modul (4) aufweist;
- eine die Belüftungsöffnungen (8) tragende Belüftungsplatte (21);
wobei dieses Avionikbucht-Gestell **dadurch gekennzeichnet ist, dass** die Belüftungsplatte (21) an ihrem Umfang mit einem Kragen (33) und mit gegenüber dem Kragen (33) angeordneten Arretierungsflächen (32) versehen ist, wobei die Belüftungsplatte (21) außerdem aufweist:
- eine Diffusionskammer (9), in die die Belüftungsöffnungen (8) münden;
- einen Kontaktstreifen (23) für das rackfähige elektrische Modul (4), wobei dieser Kontaktstreifen (23) die Diffusionskammer (9) umgibt;
wobei die Belüftungsplatte (21) so in das Belüftungsfenster (22) montiert ist, dass der Kragen (33) und die Arretierungsflächen (32) die Randleiste (29) des Belüftungsfensters (22) mit einem Spielraum umklammern, der von einer elastischen Dichtung (26) gefüllt wird, die zwischen dem Kragen (33) und der Randleiste (29) des Belüftungsfensters (22) angeordnet ist, wobei die Ebene (34), in der sich der Kontaktstreifen (23) erstreckt, fern der Ebene (30) ist, in der sich die Auflagefläche (36) des Stützrahmens erstreckt.

2. Gestell nach Anspruch 1, **dadurch gekennzeichnet, dass** die Belüftungsplatte (21) an ihrer Schmalseite eine Rille (25) für die elastische Dichtung (26) aufweist, wobei diese Rille (25) sich über den ganzen Umfang der Belüftungsplatte (21) gegenüber den Arretierungsflächen (32) erstreckt.

3. Gestell nach einem der vorhergehenden Ansprüche, **dadurch gekennzeichnet, dass** die Belüftungsplatte (21) an ihrer Schmalseite einen Schutzschirm (27) der elastischen Dichtung (26) aufweist, wobei dieser Schutzschirm (27) sich über den ganzen Umfang der Belüftungsplatte (21) erstreckt.

4. Gestell nach einem der vorhergehenden Ansprüche, **dadurch gekennzeichnet, dass** die Arretierungsflächen (32) von elastischen Laschen (31) gebildet werden, die sich im Wesentlichen lotrecht zur Belüftungsplatte (21) erstrecken, wobei diese elastische Laschen (31) an der Umrandung der Belüftungsplatte (21) verteilt sind.

5. Gestell nach Anspruch 4, **dadurch gekennzeichnet, dass** die elastischen Laschen (31) Einrastschrägen (35) der Belüftungsplatte (21) in das Belüftungsfenster (22) aufweisen.

6. Gestell nach einem der vorhergehenden Ansprüche, **dadurch gekennzeichnet, dass** die Diffusionskammer (9) von einer Schale geformt wird, die in der Dicke der Belüftungsplatte (21) geformt ist, wobei die Ränder dieser Schale den Kontaktstreifen (23) bilden.

7. Gestell nach einem der vorhergehenden Ansprüche, **dadurch gekennzeichnet, dass** der Stützrahmen (19) eine Vertiefung (28) um das Belüftungsfenster (22) herum aufweist, so dass die Randleiste (29) des Belüftungsfensters (22) von der Ebene (30) entfernt ist, in der sich die Auflagefläche (36) des Stützrahmens (19) erstreckt.

8. Gestell nach einem der vorhergehenden Ansprüche, **dadurch gekennzeichnet, dass** die Belüftungsplatte (21) elastisch verformbar ist.

9. Gestell nach einem der vorhergehenden Ansprüche, **dadurch gekennzeichnet, dass** die Belüftungsplatte (21) aus einem Stück besteht.

10. Gestell nach einem der Ansprüche 8 oder 9, **dadurch gekennzeichnet, dass** die Belüftungsplatte (21) aus einem Polymermaterial hergestellt ist.

11. Gestell nach einem der vorhergehenden Ansprüche, **dadurch gekennzeichnet, dass** die elastische Dichtung (26) einen Abstand zwischen dem Kragen (33) und der Randleiste (29) des Belüftungsfensters (22) beansprucht und die Arretierungsflächen (32) gegen die Randleiste (29) des Belüftungsfensters (22) beansprucht.

12. Gestell nach einem der vorhergehenden Ansprüche, **dadurch gekennzeichnet, dass** die Ebene (34), in der sich der Kontaktstreifen (23) erstreckt, im Wesentlichen parallel zu der Ebene (30) ist, in der sich die Auflagefläche (36) des Stützrahmens (19) erstreckt.

13. Gestell nach einem der vorhergehenden Ansprüche, **dadurch gekennzeichnet, dass** der Kontaktstreifen (23) eine ebene Oberfläche hat.

14. Verfahren zur Herstellung einer Avionikbucht, das ein Avionikbucht-Gestell nach einem der Ansprüche 1 bis 13 verwendet, **dadurch gekennzeichnet, dass** es die folgenden Schritte aufweist:
- Bestimmen der geeigneten Durchlässigkeit für den Belüftungsstrom für das Avionikbucht-Gestell abhängig vom zu installierenden rackfähigen elektrischen Modul;
- Auswahl, aus einer Vielzahl (21A, 21B, 21C, 21D) von Belüftungsplatten, die unterschiedliche Durchlässigkeiten für den Belüftungsstrom verschaffen, einer Belüftungsplatte, deren Durchlässigkeit für den Belüftungsstrom der bestimmten Durchlässigkeit für den Belüftungsstrom entspricht;
- Einbau der gewählten Belüftungsplatte in das Belüftungsfenster (22) des Gestells (7).

15. Verfahren nach Anspruch 14, **dadurch gekennzeichnet, dass** jede Belüftungsplatte der Vielzahl von Belüftungsplatten (21A, 21B, 21C, 21D) eine spezifische optische Identifikation der Durchlässigkeit für den Belüftungsstrom aufweist, die sie verschafft.

## Claims

1. Tray (7) for an avionics bay (1), said tray being intended to support, electrically connect and ventilate a rackable electrical module (4), this tray (7) having a fluidic interface wall (11) for fluidically interfacing with the avionics bay (1) and an adjacent wall (18) for electrical connection, the fluidic interface wall (11) having calibrated ventilation orifices (8), and also fastening means (20) for fastening a rackable electrical module (4) against the fluidic interface wall (11), the fluidic interface wall (11) also having:
- a ventilation window (22);
- a support frame (19) which is disposed around the ventilation window (22) and which has a bearing surface (36) for a rackable electrical module (4);
- a ventilation plate (21) bearing the ventilation orifices (8);
this avionics bay tray being **characterized in that** the ventilation plate (21) is provided with a collar (33) at its periphery and with stop surfaces (32) which are disposed facing the collar (33), the ventilation plate (21) further having:
- a diffusion chamber (9) into which the ventilation orifices (8) lead;
- a contact track (23) for the rackable electrical module (4), this contact track (23) surrounding the diffusion chamber (9);
the ventilation plate (21) being mounted in the ventilation window (22) such that the collar (33) and the stop surfaces (32) enclose the rim (29) of the ventilation window (22) with a clearance filled by an elastic seal (26) disposed between the collar (33) and the rim (29) of the ventilation window (22), the plane (34) in which the contact track (23) extends being spaced apart from the plane (30) in which the bearing surface (36) of the support frame extends.

2. Tray according to Claim 1, **characterized in that** the ventilation plate (21) has, at its edge, a recess (25) for the elastic seal (26), this recess (25) extending over the entire periphery of the ventilation plate (21), facing the stop surfaces (32).

3. Tray according to either one of the preceding claims, **characterized in that** the ventilation plate (21) has, at its edge, a protective cap (27) for the elastic seal (26), this protective cap (27) extending over the entire periphery of the ventilation plate (21).

4. Tray according to any one of the preceding claims, **characterized in that** the stop surfaces (32) are formed by elastic tabs (31) extending substantially perpendicularly with respect to the ventilation plate (21), these elastic tabs (31) being distributed over the perimeter of the ventilation plate (21).

5. Tray according to Claim 4, **characterized in that** the elastic tabs (31) have clip-fastening slopes (35) for clip-fastening the ventilation plate (21) in the ventilation window (22).

6. Tray according to any one of the preceding claims, **characterized in that** the diffusion chamber (9) is formed by a bowl produced in the thickness of the ventilation plate (21), the edges of this bowl forming the contact track (23).

7. Tray according to any one of the preceding claims, **characterized in that** the support frame (19) has an indentation (28) around the ventilation window (22) such that the rim (29) of the ventilation window (22) is spaced apart from the plane (30) in which the bearing surface (36) of the support frame (19) extends.

8. Tray according to any one of the preceding claims, **characterized in that** the ventilation plate (21) is elastically deformable.

9. Tray according to any one of the preceding claims, **characterized in that** the ventilation plate (21) is produced in one part.

10. Tray according to either of Claims 8 and 9, **characterized in that** the ventilation plate (21) is made of a polymer.

11. Tray according to any one of the preceding claims, **characterized in that** the elastic seal (26) urges a spacing between the collar (33) and the rim (29) of the ventilation window (22), and urges the stop surfaces (32) against the rim (29) of the ventilation window (22).

12. Tray according to any one of the preceding claims, **characterized in that** the plane (34) in which the contact track (23) extends is substantially parallel to the plane (30) in which the bearing surface (36) of the support frame (19) extends.

13. Tray according to any one of the preceding claims, **characterized in that** the contact track (23) has a planar surface.

14. Method for manufacturing an avionics bay, implementing an avionics bay tray in accordance with any one of Claims 1 to 13, **characterized in that** said method comprises the following steps:
- determining the ventilation flow permeability suitable for the avionics bay tray as a function of the rackable electrical module to be installed;
- choosing a ventilation plate whose ventilation flow permeability corresponds to the determined ventilation flow permeability from among a plurality (21A, 21B, 21C, 21D) of ventilation plates affording different ventilation flow permeabilities;
- mounting the chosen ventilation plate in the ventilation window (22) of the tray (7).

15. Method according to Claim 14, **characterized in that** each ventilation plate of the plurality of ventilation plates (21A, 21B, 21C, 21D) has a specific visual identification for the ventilation flow permeability that it affords.
